# EUROPEAN PATENT APPLICATION

(11) **EP 2 384 841 A2**
(43) Date of publication of application: **09.11.2011**
(21) Application number: 11003586.2
(22) Date of filing: 03.05.2011
(51) Int. Cl.: B23K 1/00, B23K 3/06

(54) **System for dispensing soft solder for mounting semiconductor chips using multiple solder wires**

(30) Priority: 04.05.2010 US 773099
(71) Applicant: ASM Assembly Automation Ltd., Kwai Chung, Hong Kong (CN)
(72) Inventor: Lam, Kui Kam, Hong Kong (CN); Tu, Pingliang, Hong Kong (CN); Ip, Chung Hung Samuel, Hong Kong (CN)
(74) Representative: Griebling, Onno

(57) **Abstract**

An apparatus (10) for dispensing solder onto a substrate (12) for mounting a semiconductor chip on the substrate comprises a dispensing body (18) and first and second dispensing channels extending through the dispensing body. Each dispensing channel is operative to receive a separate solder wire to feed the solder wire (24) to an end of the dispensing body facing the substrate. The dispensing channels are further operative to introduce the solder wires in a solid state simultaneously from the end of the dispensing body to be melted upon contact with the substrate which is heated.

## Description

### Field of the Invention

The present invention relates generally to the fabrication and packaging of integrated circuit components, and in particular, to the attachment of semiconductor chips to substrates by the use of solders.

### Background and Prior Art

Semiconductor chips may be bonded onto metallic substrates such as lead frames by soldering. Specifically, power semiconductors are commonly fixed to lead frames by using soft solder. Power devices are widely used in the automotive industry due to their high thermal and electrical performance, and soft solder is generally chosen as the chip attach layer for such semiconductor packages. The soldered joint not only provides mechanical fixation of the chip, but it also ensures that heat which is produced in the semiconductor chip during operation is dissipated more efficiently than a joint comprising a non-conductive adhesive. Additionally, the soft solder provides a good electrical path for the semiconductor chips.

In cases where there is an increase in power density of the semiconductor chip, a soldered joint having a stipulated thickness is required. The layer of solder should wet the entire area of the semiconductor chip evenly. Furthermore, it should be completely free from air cavities and contamination by impurities. The solder should not protrude from the edges nor spread beyond the surface area of the bond pad, in what is known as bleeding. To achieve this, the stipulated amount of solder should be dispensed and accurately positioned onto the substrate before bonding the semiconductor chip.

Typically, soft soldering of a semiconductor chip to a lead frame entails dispensing an amount of solder onto the lead frame before positioning the chip. This may involve touching one end of a solder wire at the position of the lead frame where the chip is to be located. The lead frame is preheated to a temperature which is above the melting point of the solder so that the solder wire melts upon contact with the lead frame. A prescribed length of the wire is fed to the lead frame and it is continuously or intermittently melted onto the lead frame. The solder wire which does not melt is then pulled back leaving a droplet of solder on the lead frame. The solder droplet remains molten when the lead frame is maintained at a temperature above the melting point of the solder. Surface tension in the molten solder leads to the formation of dome-shaped droplets on the lead frame, which inhibits the formation of a flat and even solder layer under the entire chip surface when the chip is bonded onto the solder. An additional factor that affects the proper formation of an evenly-spread layer of solder is the possible lateral deviation of the solder droplet when it is being positioned on the lead frame. It is therefore essential to modify the shape of the droplets of solder to achieve a thin and evenly spread-out layer before positioning the chip.

A conventional method to modify the shape of a solder droplet utilizes spankers. The substrate carrying a solder droplet is transferred to a spanking zone where a spanker in the form of a rectangular mold is located. The rectangular mold moves downwards to contact the solder droplet and to spread it inside the spanker mold cavity to form a rectangular footprint. A spanker typically comprises a shaft which can be lifted or lowered with respect to the substrate, and a stamp or punch connected to it wherein the stamping or punching surface faces the substrate. Deviations in thickness and position of the substrate as well as possible slanting of the substrate may adversely affect the thickness and lateral distribution of the solder. Even slight deviations in the angle between the punch surface and the surface of the substrate may lead to considerable lateral displacement of solder droplets. Additionally, flattening the solder droplets by means of the spanking stamp or punch results in solder spots which may be more or less rounded at their edges and which do not conform exactly to the rectangular or square shape of the chips.

There are disadvantages in using the spanking method to achieve a thin and even layer of molten solder. If insufficient solder is used, especially where a large solder dot volume is required, the molten solder cannot fill up the mold cavity to form an evenly distributed footprint. This affects the bonding strength between the chip and the substrate. On the other hand, when too much solder is applied, it will lead to solder splash. There is an additional need to control the quality of the spanker mold fabricated so as to minimize wetting by the liquid solder which may form contaminants in the mold cavity of the spanker. Contaminants reduce the volume of the molten solder, creating voids and weakening chip adhesion and electrical conductivity. Tilted spanker molds that may result from defective fabrication will also lead to incomplete solder footprints that affect the quality of the final product. Moreover, it is difficult to achieve complex solder footprints using spanker mold technology.

It is therefore desirable to devise alternative methods of obtaining an evenly distributed layer of molten solder for soldering a semiconductor chip to a substrate to avoid the disadvantages associated with using spankers. It is also desirable to be able to dispense a sufficient amount of molten solder more expeditiously when the semiconductor chips to be bonded are large.

### Summary of the Invention

It is thus an object of the invention to seek to provide a soft solder dispenser for forming a layer of evenly-distributed solder for attaching semiconductor chips to substrates and an expeditious method to deposit molten solder to improve the productivity of the bonding process, particularly for large semiconductor chips.

According to a first aspect of the invention, there is provided an apparatus for dispensing solder onto a substrate for mounting a semiconductor chip on the substrate, comprising: a dispensing body; and first and second dispensing channels extending through the dispensing body, each dispensing channel being operative to receive a separate solder wire to feed the solder wire to an end of the dispensing body facing the substrate; wherein the dispensing channels are operative to introduce the solder wires in a solid state simultaneously from the end of the dispensing body to be melted upon contact with the substrate which is heated.

According to a second aspect of the invention, there is provided a method for dispensing solder onto a substrate for mounting a semiconductor chip on the substrate, comprising the steps of: providing a dispensing body; passing multiple solder wires through multiple dispensing channels extending through the dispensing body; feeding the solder wire to an end of the dispensing body facing the substrate; and introducing the multiple solder wires simultaneously from the end of the dispensing body in a solid state and melting the solder wires upon contact with the substrate which is heated.

It will be convenient to hereinafter describe the invention in greater detail by reference to the accompanying drawings. The particularity of the drawings and the related description is not to be understood as superseding the generality of the broad identification of the invention as defined by the claims.

### Brief Description of the Drawings

The present invention will be readily appreciated by reference to the detailed description of,a preferred embodiment of the invention when considered with the accompanying drawings, in which:
FIG. 1 is a side view of a solder dispenser for dispensing soft solder according to the preferred embodiment of the invention;
FIG. 2 is a longitudinal cross-sectional view of a tubular body of the solder dispenser of FIG. 1; and
FiG. 3 is an isometric view of a dispenser tip of the solder dispenser of FIG. 1 incorporating a contact sensor.

### Detailed Description of the Preferred Embodiment of the Invention

The preferred embodiment of the present invention will be described hereinafter with reference to the accompanying drawings.

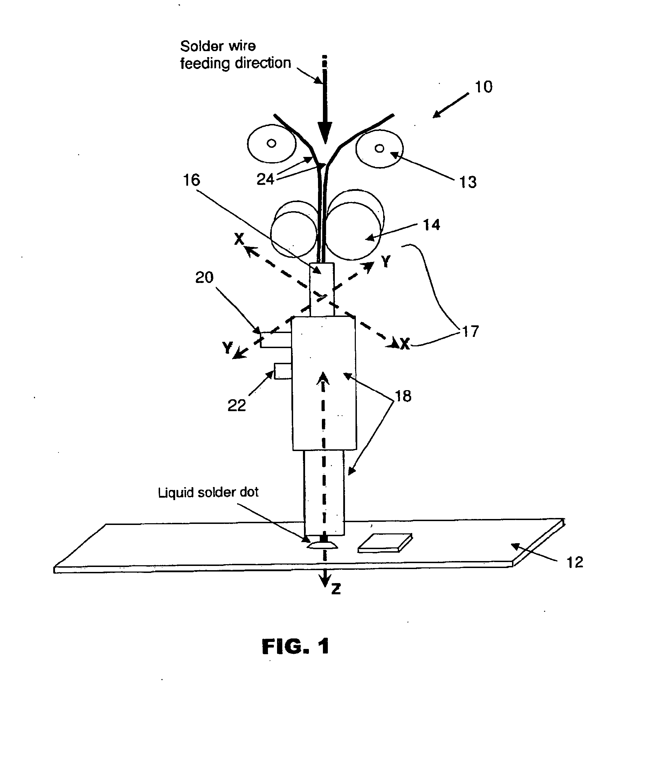

FIG. 1 is a side view of a solder dispenser 10 for dispensing soft solder according to the preferred embodiment of the invention. The solder dispenser 10 is positionable over a substrate 12 such as a lead frame or other device and a length of solder wire 24 is passed through the solder dispenser 10 for feeding the solder wire 24 to the substrate 12. In the preferred embodiment of the solder dispenser 10, two or more separate solder wires 24 are fed into and dispensed from the solder dispenser 10 simultaneously.

The solder dispenser 10 comprises a wire feeder and a dispensing body 18. The wire feeder of the preferred embodiment may comprise a pair of press rollers 14 which engage each other so that the solder wires 24 are guided via feeding channels located on the press rollers 14 for controlled feeding of the solder wires 24 into the solder dispenser 10 and towards the substrate 12 in a feeding direction. The feeding channel has a V-shaped cavity enabling the feeding channel to guide and position a solder wire 24 through the press rollers 14. The feeding direction is in a vertical or Z direction.

The solder wires 24 are guided through the press rollers 14 by wire spools 13. Since multiple solder wires 24 are fed into the solder dispenser 10, there are a corresponding number of wire spools 13 to guide the solder wires 24 through separate feeding channels on the press rollers 14 into the solder dispenser 10. A clamping force is exerted by the press rollers 14 on the solder wires 24, and the clamping force is controlled by varying the gap between the pair of pressed rollers 14 by adjusting a connecting spring or a screw (not shown). By controlling the ratio of the size of each pressed roller 14, different driving forces can be administered to feed the solder wire 24 into the solder dispenser 10. This ratio may be controlled to determine the dispensing speed of the solder wire 24. The volume of the solder wire 24 dispensed may be regulated accordingly.

The solder wires 24 that are dispensed from the solder dispenser 10 at an end of the dispensing body 18 facing a substrate 12 contact a target bond pad on the substrate 12 which is heated. The end of the solder wire 24 melts on a surface of the bond pad. The solder wires 24 form a molten solder dot or dots or a written liquid solder pattern according to a predetermined volume, position and shape. The volume and shape of the resultant solder footprint is determined by the design of the feeding channel and dispensing channels. The written liquid solder pattern is obtained from the controlled motion of the solder dispenser 10 in the X-Y horizontal directions.

A solder wire guiding nut 16 guides the solder wire 24 through a centrally-located hole in the solder dispenser 10. A positioning device, such as an X-Y table 17, is coupled to the solder dispenser 10 and configured for moving the solder dispenser 10 relative to the substrate 12 along at least one of two orthogonal axes that are substantially perpendicular to the wire feeding direction. In the described embodiment, the two orthogonal axes are the X and Y axes. The solder dispenser 10 is drivable in the X and Y directions by the X-Y table 17, and is able to dispense solder in any X-Y direction, such as diagonally onto the substrate 12, as the solder dispenser 10 moves. The X-Y table 17 may therefore move the solder dispenser 10 relative to the substrate 12 along at least one of the X and/or Y axes contemporaneously with the press rollers 14 feeding a solder wire 24 to the substrate 12 in the Z axis, whereby to dispense molten solder onto the substrate 12.

Further, the solder dispenser 10 has a solder wire cooling tube enclosing a cooling chamber located along the length of the dispensing body 18. The cooling chamber is connected to a cooling gas supply via a cooling gas inlet 20. The cooling gas leaves the cooling chamber through a cooling gas outlet 22, carrying with it the heat received from a heat tunnel on which the substrate 12 is placed.

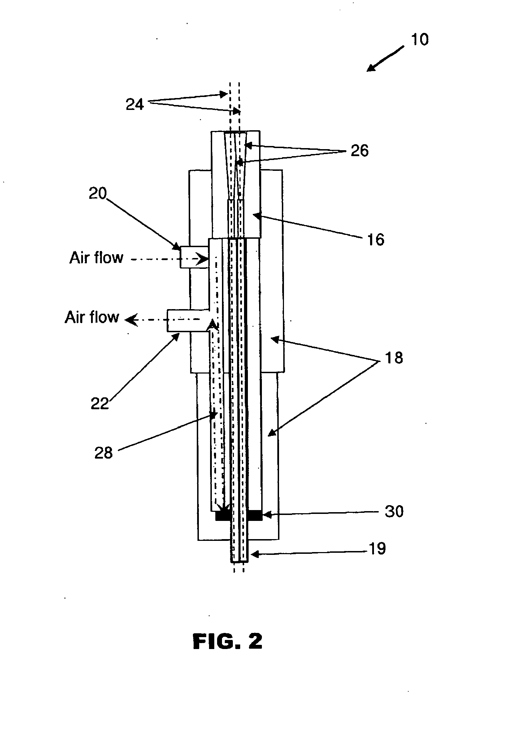

FIG. 2 is a longitudinal cross-sectional view of a tubular dispensing body 18 of the solder dispenser 10 of FIG. 1. To feed solder wires 24 smoothly into the solder dispenser 10, guide funnels 26 are located at the top of the solder dispenser 10 facing the feeding channels, and opposite to the end of the dispensing body 18 facing the substrate 12. Each guide funnel 26 guides a solder wire 24 which is fed from into a feeding channel. The guide funnels 26 are connected to first and second dispensing channels 19 extending through the dispensing body 18 and are located in a ceramic tube with a metal cover. Multiple dispensing channels 19 may receive and dispense multiple solder wires 24 simultaneously. The dispensing channels 19 and the guide funnels 26 are dielectric so as to electrically insulate the solder wire 24 in the solder dispenser 10. Together with the feeding channels which are also dielectric, the dispensing channels 19 and the guide funnels 26 allow each solder wire 24 to conduct contact searching of bond pad surface on the substrate 12 in order to dispense a sufficient amount of the solder wire 24 to form solder dots or to write a solder pattern onto the bond pad.

Further, the solder dispenser 10 has a solder wire cooling tube enclosing a cooling chamber 28 located along the length of the dispensing body 18 for dissipating heat received from a heat tunnel in which the substrate 12 is placed.

The cooling chamber 28 is connected to a cooling gas supply via a cooling gas inlet 20. Cooling gas such as compressed air is injected into the cooling chamber 28 through the cooling gas inlet 20 and leaves through a cooling gas outlet 22, thereby carrying away the heat received from the heat tunnel. This forms an air flow internally through the dispensing body 18.

The cooling gas cools the dispensing channel 19 before exiting the cooling chamber 28 at the gas outlet 22. The cooling chamber 28 is sealed near opposite ends of the dispensing body 18 using cooling gas sealants 30. The cooling process is important to maintain the solder dispenser 10 at a lower temperature to ensure that the solder wire 24 remains solid within the solder dispenser 10. By controlling the flow rate of the compressed air, the solder wires 24 are kept in solid form in the solder dispenser 10 until the wires contact the heated substrate.

Contact search with respect to the surface of the substrate 12 is usefully carried out to sense contact between the dispenser tip 32 and the substrate 12 during setup prior to dispensing the solder wire 24. Such setup allows a contact level to be measured and the feeding distance to be established, which will assist in controlling the volume of the solder wire 24 dispensed. The contact sensor and/or additional contact sensors may also be electrically connected to the solder wires 24, and operative to sense contact between the solder wire 24 and the substrate 12 at a start of a solder dispensing operation. By sensing contact between the solder wire 24 and the substrate 12 at the start of dispensing, a dispensed solder wire length during the operation can be more precisely determined.

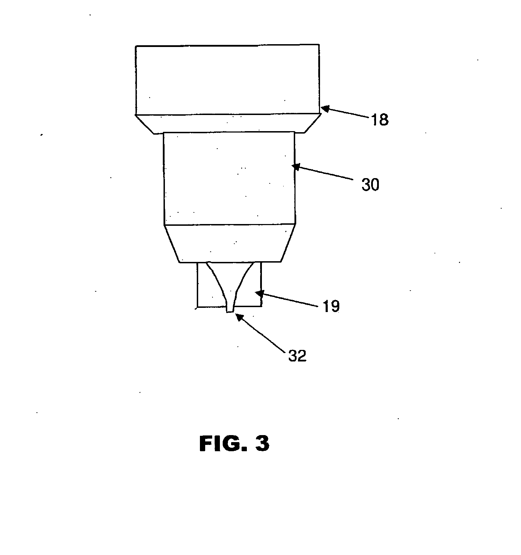

FIG. 3 is an isometric view of a dispenser tip 32 of the solder dispenser 10 of FIG. 1 incorporating a contact sensor. The dispenser tip 32 comprises a metal tip which protrudes from the dispensing channels 19. The contact sensor of the dispenser tip 32 electrically monitors contact between the metallic dispenser tip 32 and the metallic substrate 12 during setup and in order to accurately establish a dispensing level or a gap between the dispenser tip 32 and a bond pad surface. During contact searching wherein the dispensing body is incrementally lowered, the contact sensor is activated to locate a contact position at the level of the bond pad, before the dispensing body 18 moves upwards to a prescribed dispensing level spaced from the contact position at a predetermined distance over the bond pad or substrate 12. Solder wires 24 are then fed to the surface of the bond pad from the adjusted dispensing level. By maintaining the dispensing level, the contact sensor controls the volume of solder wire 24 that is dispensed onto the bond pad. Therefore, the preferred embodiment of this invention provides a method of dispensing solder wire 24 to form grid array dots or thin patterns on a bond pad with high productivity. Moreover, the contact sensor of the dispenser tip 32 or other contact sensors may be electrically connected to the solder wires 24 such that a precise moment at which the solder wires 24 contact the bond pad or substrate 12 at the start of dispensing is determined. Thereafter, a volume of dispensed solder is equivalent to a length of solder wire 24 fed to the bond pad or substrate 12 from the start of dispensing.

The following describes an exemplary solder wire dispensing process using the solder dispenser 10 according to the preferred embodiment of the invention. The solder dispenser 10 is first positioned by the X-Y table 17 over a targetted bond pad on the substrate 12. The dispenser tip 32 is configured to rest at a predetermined height from the surface of the bond pad by the contact sensor within the dispenser tip 32. At the same time, the substrate 12 is heated in an enclosed heat tunnel in a forming gas environment to a predetermined temperature, which is usually about 30 to 80° C above the melting point of the solder material.

Multiple solder wires 24 are driven through separate feeding channels by the pressed rollers 14. The solder wires 24 are guided into the dispensing channels 19 in the dispenser body 18. The temperature of the dispensing channels 19 is kept low by compressed air or other gases so that the solder wires 24 remain solid until the solder wires 24 contact the heated surface of the substrate 12. The rate of melting the solder wires 24 depends on the dispensing distance of the solder wires 24 from the heated substrate 12.

The ends of the solder wires 24 melt and form one or more liquid domes, dots or a written solder pattern depending on the manner of deposition. The solder wire 24 that is not melted and remains solid is withdrawn from the surface of the subtrate and this ends the dispensing and/or pattern-writing process on the substrate.

It should be appreciated that the preferred embodiment of the solder dispenser 10 incorporating multiple dispensing channels 19 dispensing multiple solder wires 24 simultaneously in dots or multiple written patterns as described above is advantageous over solder dispensing via a single dispensing channel. The single dispensing channel 19 usually dispenses a single solder dot in the form of a dome which is rather thick and uneven, and may not allow a die to be attached properly. Multiple small dots of solder which may be in grid array format are more effective as a thinner dome of solder is formed allowing for more precise die attachment. Dispensing solder through multiple channels at the same time forms thinner and flatter solder patterns, that is, thin domes of solder material that are more uniformly spread out. This is preferred as compared to dispensing using a single solder wire as a void-free and a more even solder layer is obtained which helps to avoid tilted chips.

Furthermore, the dispensing process using a single solder wire is slow and thus soldering productivity is low. When the semiconductor chips are large, this slow dispensing process aggravates the problem of solder oxidation. Multiple solder wire dispensing according to the preferred embodiment of this invention speeds up the dispensing process to increase productivity of soldering and decreases the extent of oxidation of the solder. Furthermore, the incidence of solder wire jamming and formation of incomplete patterns which occur frequently in a single solder wire dispenser is avoided using the pattern solder dispensing method as described above.

The invention described herein is susceptible to variations, modifications and/or additions other than those specifically described and it is to be understood that the invention includes all such variations, modifications and/or additions which fall within the spirit and scope of the above description.

## Claims

1. An apparatus for dispensing solder onto a substrate for mounting a semiconductor chip on the substrate, comprising:
a dispensing body; and
first and second dispensing channels extending through the dispensing body, each dispensing channel being operative to receive a separate solder wire to feed the solder wire to an end of the dispensing body facing the substrate;
wherein the dispensing channels are operative to introduce the solder wires in a solid state simultaneously from the end of the dispensing body to be melted upon contact with the substrate which is heated.

2. The apparatus as claimed in claim 1, further comprising a wire feeder including press rollers having multiple feeding channels into which the solder wires are inserted and clamped before being fed into the dispensing channels.

3. The apparatus as claimed in claim 2, wherein each feeding channel has a V-shaped cavity for guiding and positioning the solder wires.

4. The apparatus as claimed in claim 2, further including a gap between a pair of press rollers, and wherein the gap between the pair of press rollers is adjustable to control a clamping force on the solder wires.

5. The apparatus as claimed in claim 1, further comprising multiple wire spools, each configured to feed a solder wire to the dispensing body.

6. The apparatus as claimed in claim 1, further comprising a positioning device attached to the dispensing body which is operative to move the dispensing body relative to the substrate in directions which are perpendicular to a feeding direction of the solder wire to the substrate for writing a solder pattern on the substrate.

7. The apparatus as claimed in claim 1, further comprising a cooling chamber along a length of the dispensing body which is operative to cool the solder wire located within the dispensing body.

8. The apparatus as claimed in claim 7, further comprising a cooling gas inlet connected to the dispensing body to introduce a cooling gas into the cooling chamber and a cooling gas outlet connected to the dispensing body to remove cooling gas carrying heat away from the dispensing body.

9. The apparatus as claimed in claim 7, further comprising cooling gas sealants near opposite ends of the dispensing body that are operative to seal the cooling chamber along the length of the dispensing body.

10. The apparatus as claimed in claim 1, further comprising guide funnels connected to the dispensing channels at an opposite end of the dispensing body to the end facing the substrate for guiding each solder wire into each dispensing channel.

11. The apparatus as claimed in claim 10, wherein the guide funnels are located in a ceramic tube.

12. The apparatus as claimed in claim 1, further comprising a dispenser tip at the end of the dispensing body facing the substrate which incorporates a contact sensor that is operative to sense contact between the dispenser tip and the substrate at a contact position, so as to establish a dispensing level for the dispensing body that is spaced from the contact position.

13. The apparatus as claimed in claim 12, wherein one or more contact sensors are electrically connected to the solder wires which are operative to sense contact between the solder wires and the substrate at a start of solder dispensing, so as to calculate a dispensed wire length during solder dispensing.

14. The apparatus as claimed in claim 12, wherein the dispensing channels are made from dielectric material.

15. Method for dispensing solder onto a substrate for mounting a semiconductor chip on the substrate, comprising the steps of:
providing a dispensing body;
passing multiple solder wires through multiple dispensing channels extending through the dispensing body;
feeding the solder wire to an end of the dispensing body facing the substrate; and
introducing the multiple solder wires simultaneously from the end of the dispensing body in a solid state and melting the solder wires upon contact with the substrate which is heated.

16. Method as claimed in claim 15, wherein the multiple solder wires are melted upon contact with the substrate to form multiple dots simultaneously.

17. Method as claimed in claim 15, wherein feeding of the solder wires to the substrate in a feeding direction is conducted while moving the dispensing body perpendicular to the feeding direction so as to write one or more solder patterns on the substrate.

18. Method as claimed in claim 15, further comprising the step of sensing contact between a dispenser tip incorporating a contact sensor and the substrate at a contact position, and thereafter moving the dispensing body to a predetermined level spaced from the contact position over the substrate prior to introducing the solder wires to the substrate.

19. Method as claimed in claim 18, further comprising the step of electrically connecting one or more contact sensors to the solder wires to sense contact between the solder wires and the substrate at a start of solder dispensing, and then calculating a dispensed wire length since the start of solder dispensing.

20. Method as claimed in claim 15, further comprising the step of cooling the dispensing channels while the solder wire is being fed to the end of the dispensing body so as to maintain the solder wire in the solid state during its introduction to the substrate which is heated.
